# EUROPEAN PATENT APPLICATION

(11) **EP 0 915 508 A1**
(43) Date of publication of application: **12.05.1999**
(21) Application number: 97830507.6
(22) Date of filing: 10.10.1997
(51) Int. Cl.: H01L 21/761

(54) **Integrated circuit with highly efficient junction insulation**

(71) Applicant: STMicroelectronics S.r.l., 20041 Agrate Brianza (Milano) (IT)
(72) Inventor: Pozzoni, Massimo, 27100 Pavia (IT); Galbiati, Maria Paola, 20052 Monza (Milano) (IT); Palmieri, Michele, 20019 Settimo Milanese (Milano) (IT); Pedrazzini, Giorgio, 27100 Pavia (IT); Rossi, Domenico, 27024 Cilavegna (Pavia) (IT)
(74) Representative: Maggioni, Claudio

(57) **Abstract**

There is described an integrated circuit with junction insulation on a substrate (10) of semiconductor material comprising active regions (11, 11', 11'') of a first type of conductivity (n), insulation regions (30-33) which separate the junction-forming active regions from one another and from the substrate and means of electrical contact for reverse-biasing the junctions. In order to obtain highly efficient insulation, at least one (11) of the active regions is separated from the active regions adjacent to it (11') and from the substrate (10) by insulation regions (30-33) which form an inner insulation shell, consisting of regions (30, 31) of conductivity of a second type (p), opposite to the first type, which contains the active region (11) and an outer insulation shell, consisting of regions (32, 33) of the first type of conductivity (n) which contains the inner insulation shell.

## Description

The present invention relates to semiconductor devices and, in particular, to an integrated circuit with junction insulation as defined in the preamble of Claim 1.

In integrated circuits with junction insulation it is possible for transient conditions of abnormal bias to occur during operation, these being such as to cause the flow of unwanted currents in the substrate of the integrated circuit and within its active regions, i.e. the regions containing one or more electronic components, which are insulated from one another and from the substrate by p-n junctions which are normally reverse-biased. Transient conditions of abnormal bias mainly manifest themselves when triggering inductive loads, such as inductors and motors, which is effected via transistors of the integrated circuit which operate as electronic switches. Under these conditions some of the insulation junctions become forward-biased, so that stray transistors are turned on and give rise to stray currents which may impair the operation of the integrated circuit and, in some cases, may cause breakdown. To reduce this risk a known solution consists in designing the topography of the integrated circuit in such a way that the transistors which operate as switches are located in a position in which any stray currents produced by them during the triggering do not interfere with the operation of other components of the integrated circuit. In most cases this involves a considerable increase in the area intended for the integrated circuit. Hence, this solution runs counter to the need for ever-increasing miniaturization of integrated circuits.

The object of the present invention is to provide an integrated circuit with a more efficient junction insulation than that known and which does not require a large increase in the area of the integrated circuit.

This object is achieved according to the invention by making the integrated circuit as defined in and characterized by Claim 1.

The invention and the advantages deriving therefrom will be better understood from the following detailed description of two example embodiments thereof given with reference to the appended drawings, in which:
- Figure 1 shows a cross-section of a portion of an integrated circuit with junction insulation of known type and
- Figures 2 and 3 show cross-sections of portions of an integrated circuit with junction insulation according to two embodiments of the invention.

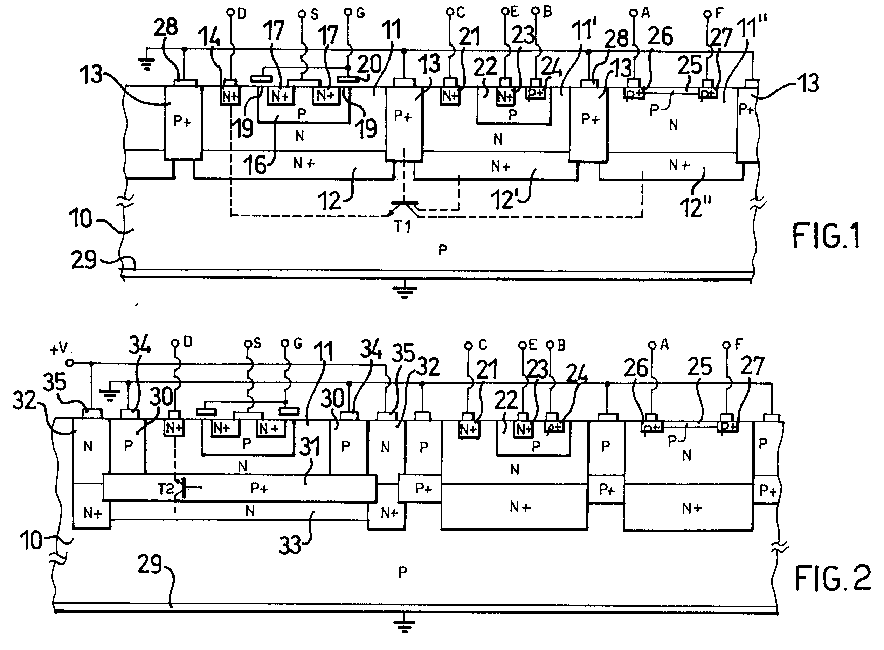

With reference to Figure 1, an integrated circuit formed on a substrate 10 of monocrystalline silicon doped with type p impurities comprises various active regions, only three of which are represented in the drawings and are marked 11, 11', 11'', formed in an epitaxial layer of type n. These regions 11, 11' and 11'' are separated from the substrate 10 by buried layers 12, 12', 12'' of strongly doped type n, and hence marked n+, and are separated from one another by insulation regions 13 of strongly doped type p, and hence marked p+.

A lateral MOS type power transistor is formed in one of the active regions, the one marked 11. A planar region 14 which is strongly doped with type n impurities and a metal contact element which constitutes the drain terminal D of the transistor are formed in the region 11. A planar region 16 of type p is formed inside the n region 11 and constitutes the body region of the transistor. A planar region 17 which is strongly doped with n type impurities is formed inside the body region 16 and constitutes the source region of the transistor. A second metal contact electrode is formed on the front surface in contact with the source and body regions and constitutes the source terminal S of the transistor. The source region 17 delimits a channel 19 with the edges of the body region 16. The channel 19 lies below a third electrode, marked 20, which is insulated from the front surface by a gate dielectric (not represented) and constitutes the gate terminal G of the transistor.

The other two active areas 11' and 11'' represented in the drawing contain, by way of example, a vertical npn transistor and a resistor, respectively.

In the active area 11' is formed a collector contact n+ planar region 21 on which is formed a collector electrode C, and a p region 22 which constitutes the base region of the transistor and contains an emitter n+ region 23 and a base contact p+ region 24. Emitter E and base B contact electrodes are formed on the emitter 23 and base 24 regions respectively.

In the active area 11'' is formed a p region 25 which constitutes the body of the resistor and two p+ regions 26 and 27 for contact between the resistor and respective electrodes which constitute the terminals A and F of the resistor.

Metal contact electrodes 28 and 29 are formed on the front surfaces of the insulation regions 13 and on the bottom surface of the substrate. Normally, during operation of the integrated circuit, these electrodes are linked to the terminal with the lowest potential in the integrated circuit, for example to the negative terminal of the power supply, indicated in the drawing by the earth symbol.

Since the active regions are normally linked, via for example the drain terminal D of the lateral MOS transistor and the collector terminal C of the vertical npn transistor, to the positive terminal of a voltage supply, the p-n junctions which these form with the regions which contain them, i.e. with the substrate 10 and with the insulation regions 13, are reverse-biased and hence electrically insulate the active regions from one another and from the substrate.

However, if the lateral MOS power transistor formed in the active region 11 is made to operate as an electronic switch of an inductive load, the drain terminal D may drop momentarily to a potential below that of earth, so that the insulation junction is made to conduct. Under these conditions the stray npn transistor T1 which has the p substrate 10 as its base, the n active region, or drain region, 11 of the MOS power transistor being its emitter and the adjacent active regions 11' and 11'' as its collectors, is conducting. Hence a stray current passes from the active regions 11', 11'' to the drain terminal D flowing through the substrate 10 and interfering with the operation of the components contained in the active regions.

The cross-section of Figure 2, where elements identical or equivalent to those of Figure 1 are indicated with the same reference number, shows, in cross-section, a portion of an integrated circuit according to a first example embodiment of the invention. In this example the active region 11 which contains the MOS power transistor is electrically insulated from the substrate 10 by insulation regions which form an inner shell and an outer shell. The inner shell consists of a p type insulation region 30 which laterally surrounds the active region 11 and of a p type buried region 31 which extends over the whole of the bottom of the active region meeting up with the insulation region 30. The outer shell consists of an n insulation region 32 which surrounds the p type insulation region 30 and of an n type buried region 33 which extends below the p type buried region 31, meeting up with the n type insulation region 32. Metal contact electrodes 34 and 35 are formed on the surfaces of the insulation regions, of type p 30 and of n type 32 respectively, with one of them linked to the negative terminal (earth) and the other to the positive terminal +V of a voltage supply. A reverse-biased junction is thus formed between the regions of the inner shell and those of the outer shell which, together with the junction, the latter also normally reverse-biased, between the active region 11 and the regions 30 and 31 of the inner shell, constitutes a highly efficient insulation structure.

Consider in particular the critical situation, described at the outset, in which the potential of the drain terminal of the MOS power transistor drops below the earth level, so that the junction between the active region 11 and the inner insulation shell becomes forward-biased. Under this condition the stray npn transistor T2, which has the drain region 11 as its emitter, the p type insulation regions 30 and 31 as its base and the n type insulation regions 32 and 33 as its collector, becomes conducting. A current flows from the positive terminal of the voltage supply +V to the drain electrode D without disturbing the components of the integrated circuit.

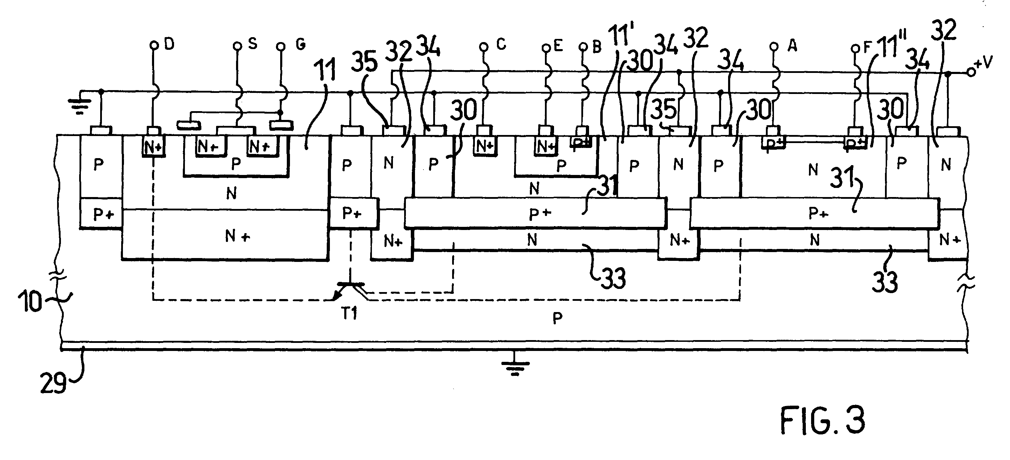

Another example embodiment of the invention is shown in Figure 3. A portion of the integrated circuit again contains an MOS power transistor in an active region 11 and an npn transistor and a resistor in two active regions 11' and 11''. In this example, however, the MOS power transistor is insulated in the conventional manner, while the npn transistor and the resistor are insulated with a double shell, in the same way as the active region 11 in the example of Figure 2. The insulation regions are identified by the same reference numbers as those used in Figure 2.

As may be easily verified, the critical situation which occurs when the drain electrode D goes to a lower potential than earth gives rise to the injection of a current into the substrate, as in the structure according to the known art illustrated in Figure 1. However, when the stray transistor, here also marked T1 and which has the drain region of the MOS power transistor as its emitter, the substrate as its base and the insulation regions 32 and 33 of the outer shell of the insulation structures of the npn transistor and of the resistor as its collectors, is made to conduct under the conditions described above, it transports the current from the positive termial +V of the voltage supply to the drain terminal D of the MOS power transistor without passing through the active regions adjacent to that of the MOS power transistor and hence without interfering with the operation of the components contained in them.

Naturally, if the insulation structures according to the example of Figure 2 and that of Figure 3 were in certain cases insufficient to avoid malfunctions due to stray currents, it would be possible to adopt the double-shell insulation for all the components, i.e. it is possible to make an insulation structure consisting of the sum of the insulation structures of Figures 2 and 3.

To make the integrated circuit according to the invention a person skilled in the art is aware of the processes to which to resort. A suitable process is, for example, described in European application 96830280 filed on 14.05.96 by the Applicant.

As may readily be appreciated, the object of the invention is achieved in full since, using the novel insulation structure, any stray currents, due for example to the triggering of an electronic switch with inductive load, do not interfere with the components contained in the active regions adjacent to that containing the electronic switch. Moreover, this result is achieved with a relatively slight increase in the area of the integrated circuit, i.e. with the addition of the area required by the type n insulation regions marked 32 in Figures 2 and 3, which, in the case of the example of Figure 2, are necessary only around the active area of the power transistor.

## Claims

1. Integrated circuit with junction insulation on a substrate (10) of semiconductor material comprising
a multiplicity of active regions (11, 11', 11'') of a first type of conductivity (n),
a multiplicity of insulation regions (30-33) which separate the junction-forming active regions from one another and from the substrate and
means of electrical contact (34, 35, 29) for reverse-biasing the junctions,
characterized in that at least one (11) of the active regions is separated from the active regions adjacent to it (11') and from the substrate (10) by insulation regions (30-33) which form an inner insulation shell, consisting of regions (30, 31) of conductivity of a second type (p), opposite to the first type, which contains the active region (11) and an outer insulation shell, consisting of regions (32, 33) of the first type of conductivity (n) which contains the inner insulation shell.

2. Integrated circuit according to Claim 1, in which the insulation regions which form the inner insulation shell comprise a first insulation region (30) which laterally surrounds the active region (11) and a second insulation region (31) which extends over the whole of the bottom of the active region (11) meeting up with the first insulation region (30), in which the insulation regions which form the outer insulation shell comprise a third insulation region (32) which laterally surrounds the first insulation region (30) and a fourth insulation region (33) which extends beneath the second insulation region (31) meeting up with the third insulation region (32) and in which the means of electrical contact for reverse-biasing the junctions comprise metal contact electrodes (34, 35) on the first (30) and on the third (32) insulation region.

3. Integrated circuit according to Claim 1 or 2, in which the aforesaid, at least one, active region (11) contains a power component able to operate as an electronic switch.
